# EUROPEAN PATENT APPLICATION

(11) **EP 4 589 269 A1**
(43) Date of publication of application: **23.07.2025**
(21) Application number: 22958650.8
(22) Date of filing: 21.12.2022
(51) Int. Cl.: G01J 1/44, H01L 27/14, G01J 5/10

(54) **LINEAR PHOTOELECTRIC FOCAL PLANE DETECTOR AND MANUFACTURING METHOD THEREFOR**

(30) Priority: 15.09.2022 CN 202211131607
(71) Applicant: WUXI ZHONGKE DEXIN SENSING TECHNOLOGY CO., LTD., Wuxi, Jiangsu 214028 (CN); Shanghai Institute of Technical Physics of the Chinese Academy of Science, Shanghai 200083 (CN)
(72) Inventor: LI, Xue, Wuxi, Jiangsu 214028 (CN); LIU, Dafu, Wuxi, Jiangsu 214028 (CN); LI, Tao, Wuxi, Jiangsu 214028 (CN); SUN, Duo, Wuxi, Jiangsu 214028 (CN)
(74) Representative: Murgitroyd & Company
(86) International application number: PCT/CN2022/140576
(87) International publication number: WO 2024/055463

(57) **Abstract**

A linear photoelectric focal plane detector and a manufacturing method therefor. The linear photoelectric focal plane detector comprises a photosensitive chip (2) and a readout circuit (1), wherein the upper surface of the readout circuit (1) is provided with a plurality of rows of first metal electrodes (11), the first metal electrodes (11) in each row are arranged in parallel at equal intervals in a row direction, and the first metal electrodes (11) in adjacent rows are arranged in a staggered manner in the row direction; and the photosensitive chip (2) comprises at least one row of photosensitive pixels (21) arranged in parallel, the lower surface of the photosensitive chip (2) is provided with second metal electrodes (22) arranged in parallel at equal intervals in the row direction, and at least one row of second metal electrodes (22) are correspondingly connected to the first metal electrodes (11). A plurality of photosensitive chips (2) of different structures are designed on the basis of one readout circuit (1) in a matching manner, so as to generate linear photoelectric focal plane detectors with different detection scales and center distances between pixels, such that manufacturing costs can be reduced. By using the readout circuit (1) of the same structure, a mechanical interface and electrical properties are effectively prevented from being adjusted, thereby improving the usability of a photoelectric detector.

## Description

The present application claims the right of the priority of Chinese patent application 2022111316074 filed on September 15, 2022. The contents of the Chinese patent application are incorporated herein by reference in their entirety.

### TECHNICAL FIELD

The present disclosure relates to the field of semiconductor technology, and particularly to a linear photoelectric focal plane detector and a manufacturing method therefor.

### BACKGROUND

Photoelectric detectors, by converting optical signals into electrical signals, enable the electronic image processing of information on a certain scene, thereby obtaining the data information data that needs to be extracted. Photoelectric detectors are widely used in digital imaging, spectral analysis, industrial detection, scientific research, and other fields. Compared to photoelectric detectors with area array structures, linear array detectors are commonly used in industrial detection, grain color sorting, and other fields due to their advantages of low cost and ease of implementation.

Photosensitive chips made of non-silicon-based materials need to be used in combination with silicon-based readout circuits. Therefore, the structures of the photosensitive chip and the readout circuit of each photoelectric focal plane detector model generally need to be matched. The readout circuit of each photoelectric detector model is designed and processed separately, which increases the manufacturing cost of the photoelectric detector. Additionally, the back-end electronics require personalized design according to the mechanical interface and electrical properties of each photoelectric detector, which increases the cost and difficulty of application of the photoelectric detector.

### CONTENT OF THE PRESENT INVENTION

The technical problem to be solved by the present disclosure is to provide a linear photoelectric focal plane detector and a manufacturing method therefor in order to overcome the defect in the prior art that the photosensitive chip of each plane detector needs to be individually matched with the readout circuit of the corresponding structure, resulting in high manufacturing and application costs.

The present disclosure solves the above technical problem by the following technical solutions:
In a first aspect, the present disclosure provides a linear photoelectric focal plane detector, comprising a photosensitive chip and a readout circuit; the photosensitive chip is electrically connected to the readout circuit; the readout circuit is fixedly disposed underneath the photosensitive chip for reading a photoelectric conversion signal from the photosensitive chip;
an upper surface of the readout circuit is provided with a plurality of rows of first metal electrodes; the first metal electrodes in each row are arranged in parallel at equal intervals in a row direction, and the first metal electrodes in adjacent rows are arranged in a staggered manner in the row direction;
the photosensitive chip comprises at least one row of photosensitive pixels arranged in parallel; a lower surface of the photosensitive chip is provided with second metal electrodes arranged in parallel at equal intervals in the row direction, and at least one row of the second metal electrodes are correspondingly connected to the first metal electrodes.

Preferably, the linear photoelectric focal plane detector further comprises an interconnection layer, through which the photosensitive chip is electrically connected to the readout circuit.

Preferably, the interconnection layer comprises metal interconnection bumps correspondingly provided on the upper surface of the readout circuit and the lower surface of the photosensitive chip and distributed in an array pattern.

Preferably, the metal interconnection bump comprises a first metal interconnection bump protruding from the first metal electrode and a second metal interconnection bump protruding from the second metal electrode.

Preferably, the second metal electrode and the photosensitive pixel are electrically connected through a signal electrode.

Preferably, the upper surface of the readout circuit is further provided with a number of metal pads for electrical connection with an external interface to transmit the photoelectric conversion signal processed by the readout circuit to the external interface.

Preferably, the metal pad transmits the photoelectric conversion signal processed by the readout circuit to the external interface by means of wire bonding.

Preferably, the photosensitive pixels are in a plurality of rows, with each row of the photosensitive pixels having the same size of photosensitive surface.

In a second aspect, the present disclosure provides a manufacturing method for a linear photoelectric focal plane detector, comprising:
providing a plurality of rows of first metal electrodes on an upper surface of a readout circuit; the first metal electrodes in each row being arranged in parallel at equal intervals in a row direction, and the first metal electrodes in adjacent rows being arranged in a staggered manner in the row direction;
obtaining a plurality of photosensitive chips of different types; each photosensitive chip comprising at least one row of photosensitive pixels arranged in parallel;
providing second metal electrodes arranged in parallel at equal intervals in the row direction on a lower surface of each photosensitive chip; at least one row of the second metal electrodes being correspondingly connected to the first metal electrodes.

Preferably, the manufacturing method further comprises:
providing a first metal interconnection bump protruding from the first metal electrode and a second metal interconnection bump protruding from the second metal electrode;
forming an interconnection layer based on the first metal interconnection bump and the second metal interconnection bump;
   and/or,
electrically connecting the photosensitive pixel to the second metal electrode using a signal electrode.

The positive and progressive effect of the present disclosure is that: the present disclosure provides a linear photoelectric focal plane detector and a manufacturing method therefor, wherein the linear photoelectric focal plane detector comprises a plurality of photosensitive chips of different structures designed on the basis of one readout circuit in a matching manner, so as to generate linear photoelectric focal plane detectors with different pixel scales and center distances between pixels, such that the manufacturing cost of photoelectric detectors can be reduced. By using readout circuits of the same structure, the mechanical interface and electrical properties are effectively prevented from being adjusted during the development of back-end electronic structures, requiring only modifications to the signal processing algorithms on the software side, which can significantly reduce the application cost and improve the usability of photoelectric detectors.

### BRIEF DESCRIPTION OF THE DRAWINGS

FIG. 1 is a first structural schematic diagram of a linear photoelectric focal plane detector with a pixel number of 512×2 according to Example 1 of the present disclosure;
FIG. 2 is a second structural schematic diagram of the linear photoelectric focal plane detector with a pixel number of 512×2 according to Example 1 of the present disclosure;
FIG. 3 is a first structural schematic diagram of a linear photoelectric focal plane detector with a pixel number of 1024×1 according to Example 1 of the present disclosure;
FIG. 4 is a first structural schematic diagram of a linear photoelectric focal plane detector with a pixel number of 256×2 according to Example 1 of the present disclosure;
FIG. 5 is a flow chart of a manufacturing method for a linear photoelectric focal plane detector according to Example 2 of the present disclosure.

### DETAILED DESCRIPTION OF THE PREFERRED EMBODIMENT

The present disclosure is further described below by way of examples, but the present disclosure is not thereby limited to the scope of the described examples.

### Example 1

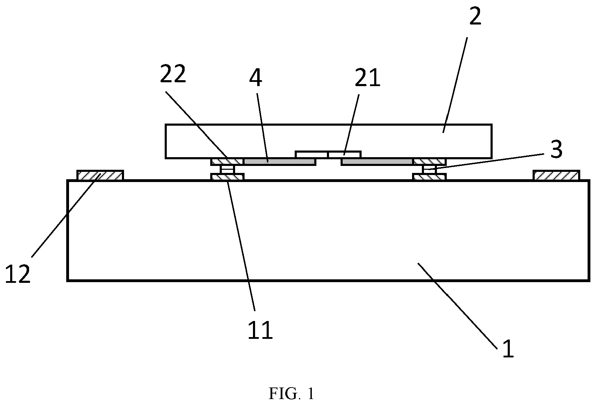

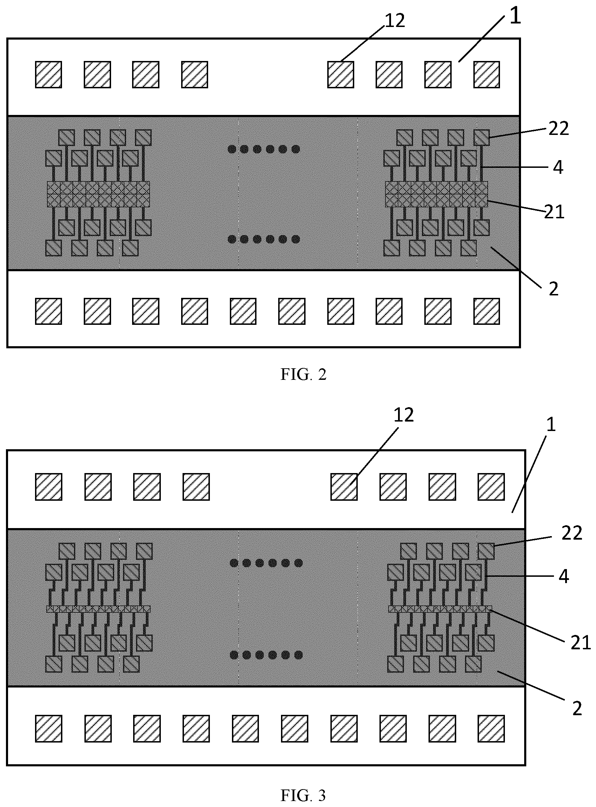

FIGs. 1 and 2 are the first and second structural schematic diagrams of a linear photoelectric focal plane detector with a pixel number of 512×2 according to Example 1 of the present disclosure. The linear photoelectric focal plane detector comprises a readout circuit 1 and a photosensitive chip 2; the readout circuit 1 is electrically connected to the photosensitive chip 2; the readout circuit 1 is fixedly disposed underneath the photosensitive chip 2 for reading a photoelectric conversion signal from the photosensitive chip 2;
an upper surface of the readout circuit 1 is provided with a plurality of rows of first metal electrodes 11; the first metal electrodes 11 in each row are arranged in parallel at equal intervals in a row direction, and the first metal electrodes 11 in adjacent rows are arranged in a staggered manner in the row direction;
the photosensitive chip 2 comprises at least one row of photosensitive pixels 21 arranged in parallel; a lower surface of the photosensitive chip 2 is provided with second metal electrodes 22 arranged in parallel at equal intervals in the row direction, and at least one row of the second metal electrodes 22 are correspondingly connected to the first metal electrodes 11.

In this example, the absorption layer of the linear photoelectric detector can be made of InGaAs or HgCdTe materials, enabling infrared signal detection.

FIG. 1 shows a linear photoelectric focal plane detector with a pixel number of 512×2, in which the photosensitive chip 2 comprises two rows of photosensitive pixels 21 arranged in parallel with a center distance of 30 µm between adjacent pixels in both the row and column directions. The photosensitive chip 2 adopts a back-illuminated structure, meaning it receives optical signals from the backside of the chip. The readout circuit 1 has functions such as reading, processing, and amplification of electrical signals. The photosensitive pixel 21 has a size of 30 µm×30 µm, which is adjusted according to actual conditions. The upper surface of the readout circuit 1 is provided with 256×4 first metal electrodes 11, and the lower surface of the photosensitive chip 2 is correspondingly provided with 256×4 second metal electrodes 22. Specifically, 256×2 second metal electrodes 22 can be respectively distributed on the upper and lower sides of the photosensitive pixel 21. Each first metal electrode 11 and each second metal electrode 22 are positioned correspondingly and connected to each other. Each row of the first metal electrodes 11 and each row of the second metal electrodes 22 are arranged in a staggered manner in the column direction.

FIG. 3 shows a linear photoelectric focal plane detector with a pixel number of 1024×1, in which the photosensitive chip 2 comprises one row of photosensitive pixels 21 arranged in parallel with a center distance of 15 µm between adjacent pixels in the row direction. The photosensitive pixel 21 has a size of 15 µm×15 µm, which is adjusted according to actual conditions. The readout circuits 1 of the linear photoelectric detectors with pixel sizes of 1024×1 and 512×2 are identical, achieving two photoelectric detectors of different scales and pixel sizes with high readout circuit versatility based on the same readout circuit 1. Specifically, in this linear photoelectric focal plane detector, the upper surface of the readout circuit 1 is provided with 256×4 first metal electrodes 11, and the lower surface of the photosensitive chip 2 is correspondingly provided with 256×4 second metal electrodes 22. Each first metal electrode 11 and each second metal electrode 22 are positioned correspondingly and electrically connected.

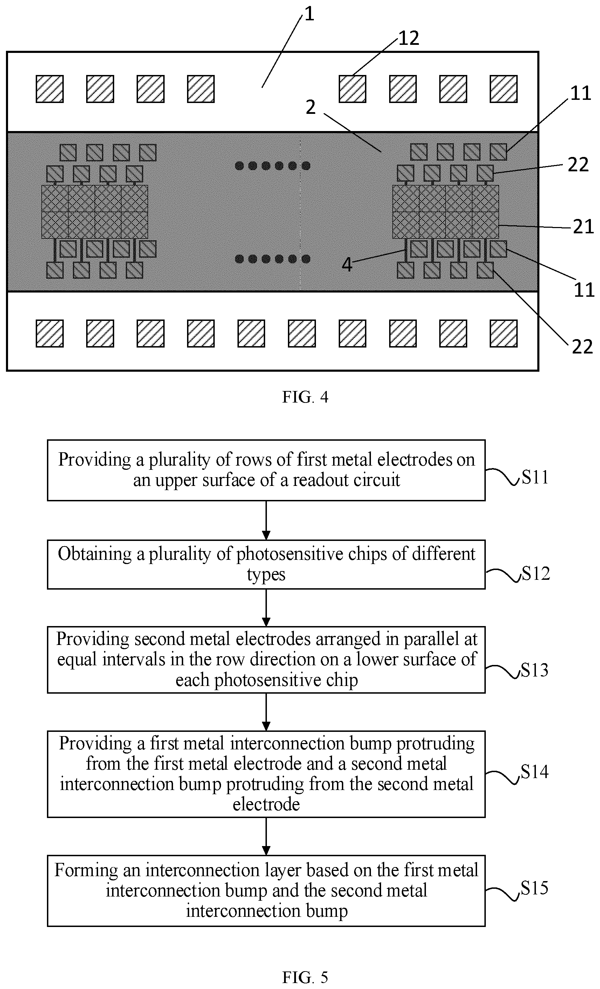

FIG. 4 shows a linear photoelectric focal plane detector with a pixel number of 256×2, in which the photosensitive chip 2 comprises two rows of photosensitive pixels 21 arranged in parallel with a center distance of 60 µm between adjacent pixels in the row direction. The photosensitive pixel 21 has a size of 60 µm×60 µm, which is adjusted according to actual conditions. One row of second metal electrodes 22 arranged in parallel at equal intervals in the row direction are respectively provided on the upper and lower sides of the photosensitive pixel 21, and two rows of first metal electrodes 11 corresponding to the positions of the second metal electrodes 22 as well as two other rows of first metal electrodes 11 not corresponding to the positions of the second metal electrodes 22 are provided on the upper surface of the readout circuit 1, so as to form an arrangement in which the second metal electrodes 22 and the first metal electrodes 11 are provided in a sequentially staggered manner in the row direction. It should be noted that the upper and lower sides described above are only used to illustrate the relative positional relationship between the metal electrode and the photosensitive pixel 21.

As a preferred embodiment, the linear photoelectric focal plane detector further comprises an interconnection layer 3, through which the photosensitive chip 2 is electrically connected to the readout circuit 1.

The interconnection layer 3 can be formed by coupling and interconnecting the first metal electrodes 11 and the second metal electrodes 22 correspondingly provided on the photosensitive chip 2 and the readout circuit 1 through a flip-chip process, which enables electrical connection and mechanical support between the photosensitive chip 2 and the readout circuit 1, thereby enabling the readout of photoelectric conversion signals.

As a preferred embodiment, as shown in FIGs. 2 and 3, the interconnection layer 3 comprises metal interconnection bumps correspondingly provided on the upper surface of the readout circuit 1 and the lower surface of the photosensitive chip 2 and distributed in an array pattern. The metal interconnection bump comprises a first metal interconnection bump protruding from the first metal electrode 11 and a second metal interconnection bump protruding from the second metal electrode 22.

Each first metal electrode 11 and each second metal electrode 22 are correspondingly connected. The first and second metal interconnection bumps are electrode bumps with a certain height.

As a preferred embodiment, the second metal electrode 22 and the photosensitive pixel 21 are electrically connected through a signal electrode 4. As shown in FIGs. 2, 3, and 4, a plurality of photosensitive chips 2 with different linear pixel sizes and center distances between pixels have their electrical signals elicited from the photosensitive pixel 21 through the signal electrode 4 to the second metal electrode 22, which matches the position of the surface metal electrode of the readout circuit 1.

As a preferred embodiment, the upper surface of the readout circuit 1 is further provided with a number of metal pads 12 for electrical connection with an external interface to transmit the photoelectric conversion signal processed by the readout circuit 1 to the external interface.

As shown in FIG. 2, the metal pads 12 are disposed on both sides of the upper surface of the readout circuit 1. These metal pads 12 serve as metal electrodes and transmit the photoelectric conversion signals processed by the readout circuit 1 to the external interface by means of wire bonding, thereby enabling the transmission of electrical signals.

As a preferred embodiment, the photosensitive pixels 21 are in a single row or a plurality of rows, with each row of the photosensitive pixels 21 having the same size of photosensitive surface.

As shown in FIGs. 2 and 4, the photosensitive pixels 21 in each row are arranged at equal intervals in the row direction, and the photosensitive pixels 21 in adjacent rows are aligned in the row direction. The photosensitive pixels 21 have the same size of photosensitive surface in both the column and row directions. It should be noted that the size of photosensitive surface of the photosensitive pixels 21 can be redetermined or adjusted according to actual requirements without specific restrictions herein.

In this example, a plurality of photosensitive chips of different structures are designed on the basis of one readout circuit in a matching manner, so as to generate linear photoelectric focal plane detectors with different detection scales and center distances between pixels, such that the manufacturing cost can be reduced. By using readout circuits of the same structure, the mechanical interface and electrical properties are effectively prevented from being adjusted, thereby improving the usability of photoelectric detectors.

### Example 2

FIG. 5 is a flow chart of a manufacturing method for a linear photoelectric focal plane detector according to Example 2 of the present disclosure. The manufacturing method comprises:
S11: providing a plurality of rows of first metal electrodes on an upper surface of a readout circuit; the first metal electrodes in each row being arranged in parallel at equal intervals in a row direction, and the first metal electrodes in adjacent rows being arranged in a staggered manner in the row direction.
S12: obtaining a plurality of photosensitive chips of different types; each photosensitive chip comprising at least one row of photosensitive pixels arranged in parallel.
S13: providing second metal electrodes arranged in parallel at equal intervals in the row direction on a lower surface of each photosensitive chip; at least one row of the second metal electrodes being correspondingly connected to the first metal electrodes.

Regarding step S11 mentioned above, a silicon-based readout circuit that can simultaneously accommodate multiple photosensitive chip structures with a multi-row linear electrical signal readout unit structure is fabricated. The first metal electrodes provided on the upper surface of the readout circuit are characterized by being arranged in parallel between rows in the row direction with consistent center distances, and being arranged in a staggered manner in the column direction.

Regarding step S12 mentioned above, a plurality of photosensitive chips with different linear pixel sizes and center distances between pixels are obtained. For example, a photosensitive chip with a pixel number of 512×2 and a center distance of 30 µm between pixels, a photosensitive chip with a pixel number of 1024×1 and a center distance of 15 µm between pixels, and a photosensitive chip with a pixel number of 256×2 and a center distance of 60 µm between pixels. Each photosensitive chip may comprise one row of photosensitive pixels arranged in parallel at equal intervals in the row direction, or may comprise two rows of photosensitive pixels arranged in parallel at equal intervals in the row direction. In this example, the arrangement of photosensitive pixels can be adjusted according to actual conditions without specific restrictions.

Regarding step S13 mentioned above, for different types of photosensitive chips, second metal electrodes arranged in different rows and columns are provided, and each row of the second metal electrodes are arranged in parallel at equal intervals in the row direction. For example, for a photosensitive chip with a pixel number of 512×2 and a center distance of 30 µm between pixels, when the upper surface of the readout circuit is provided with 256×4 first metal electrodes, the lower surface of the photosensitive chip is provided with 256×4 second metal electrodes at positions corresponding to the first metal electrodes. Specifically, 256×2 second metal electrodes can be respectively distributed on the upper and lower sides of the photosensitive pixel.

For a photosensitive chip with a pixel number of 256×2 and a center distance of 60 µm between pixels, when the upper surface of the readout circuit is provided with 256×4 first metal electrodes, the lower surface of the photosensitive chip is provided with 256×2 second metal electrodes. Specifically, 256×1 second metal electrodes can be respectively distributed on the upper and lower sides of the photosensitive pixel. That is, there are only 256×1 second metal electrodes on the upper or lower side of the photosensitive pixel, which are correspondingly connected to 256×1 first metal electrodes at the relative positions on the readout circuit.

As a preferred embodiment, the photosensitive pixel is electrically connected to the second metal electrode using a signal electrode. Specifically, electrical signals on the lower surface of the photosensitive pixel are elicited from the photosensitive pixel through the signal electrode to the second metal electrode corresponding to the position of the first metal electrode provided on the upper surface of the readout circuit.

As a preferred embodiment, the manufacturing method further comprises:
S14: providing a first metal interconnection bump protruding from the first metal electrode and a second metal interconnection bump protruding from the second metal electrode.
S15: forming an interconnection layer based on the first metal interconnection bump and the second metal interconnection bump.

Regarding step S14 mentioned above, on the upper surface of the metal electrodes of the readout circuit, there are metal interconnection bumps of a certain height, referred to as the first metal interconnection bumps. Similarly, on the lower surface of the metal electrodes of the photosensitive chip, at positions corresponding to some of the first metal interconnection bumps, there are also second metal interconnection bumps of a certain height.

Regarding step S15 mentioned above, the interconnection layer is formed by coupling and interconnecting the first metal interconnection bumps protruding from the first metal electrodes of the readout circuit and the second metal interconnection bumps protruding from the second metal electrodes of the photosensitive chip through a flip-chip process. The interconnection layer not only enables electrical connection and mechanical support between a specific readout circuit and each different type of photosensitive chip, but also enables the readout of photoelectric conversion signals.

As a preferred embodiment, based on the signal electrode design logic of each pixel on the photosensitive chip, the electrical signals obtained by the readout circuit are processed through back-end electronic structures, and effective photoelectric conversion signals are selected and combined according to their positional relationships to form a complete detection image, thereby enabling the application of multiple linear photoelectric focal plane detectors based on one readout circuit.

For example, when the detector starts operating, the electrical signals of the linear detector with a pixel number of 512×2 are read out sequentially from left to right or from right to left, and can be output in the back-end electronic structure to form a detection image composed of two rows of pixels, with each row having a length of 512 pixels. For the linear detector with a pixel number of 1024×1, the electrical signals need to be stitched and combined for readout in the back-end electronic structure. That is, the electrical signals from the upper and lower sides are alternately stitched in sequence to form a detection image composed of a single row of pixels, with the row having a length of 1024 pixels. For the linear detector with a pixel number of 256×2, the electrical signals need to be read out through a leapfrog combination in the back-end electronic structure. That is, the electrical signals from one side are read out in accordance with a method of combining the odd signals in sequence while hiding the even signals to form a detection image composed of two rows of pixels, with each row having a length of 256 pixels. The method allows for the creation of multiple photoelectric detectors with different pixel scales and sizes based on the same readout circuit, demonstrating high readout circuit versatility.

In this example, the manufacturing method for the linear photoelectric focal plane detector is based on one readout circuit structure, enabling the design of multiple photosensitive chip structures in a matching manner, so as to generate linear photoelectric focal plane detectors with different detection scales and center distances between pixels. By using readout circuits of the same structure, the mechanical interface and electrical properties can be prevented from being adjusted in a matching manner during the development of back-end electronic structures, which effectively improves the usability of photoelectric focal plane detectors and the versatility of readout circuits.

Although the specific embodiments of the present disclosure have been described above, it should be understood by those skilled in the art that these are merely illustrative examples, and the scope of protection of the present disclosure is defined by the appended claims. Those skilled in the art can make various changes or modifications to these embodiments without departing from the principles and essence of the present disclosure, but these changes and modifications fall within the scope of protection of the present disclosure.

## Claims

1. A linear photoelectric focal plane detector, comprising a photosensitive chip and a readout circuit; the photosensitive chip is electrically connected to the readout circuit; the readout circuit is fixedly disposed underneath the photosensitive chip for reading a photoelectric conversion signal from the photosensitive chip;
an upper surface of the readout circuit is provided with a plurality of rows of first metal electrodes; the first metal electrodes in each row are arranged in parallel at equal intervals in a row direction, and the first metal electrodes in adjacent rows are arranged in a staggered manner in the row direction;
the photosensitive chip comprises at least one row of photosensitive pixels arranged in parallel; a lower surface of the photosensitive chip is provided with second metal electrodes arranged in parallel at equal intervals in the row direction, and at least one row of the second metal electrodes are correspondingly connected to the first metal electrodes.

2. The linear photoelectric focal plane detector according to claim 1, further comprising an interconnection layer, through which the photosensitive chip is electrically connected to the readout circuit.

3. The linear photoelectric focal plane detector according to claim 2, wherein the interconnection layer comprises metal interconnection bumps correspondingly provided on the upper surface of the readout circuit and the lower surface of the photosensitive chip and distributed in an array pattern.

4. The linear photoelectric focal plane detector according to claim 3, wherein the metal interconnection bump comprises a first metal interconnection bump protruding from the first metal electrode and a second metal interconnection bump protruding from the second metal electrode.

5. The linear photoelectric focal plane detector according to claim 1, wherein the second metal electrode and the photosensitive pixel are electrically connected through a signal electrode.

6. The linear photoelectric focal plane detector according to claim 1, wherein the upper surface of the readout circuit is further provided with a number of metal pads for electrical connection with an external interface to transmit the photoelectric conversion signal processed by the readout circuit to the external interface.

7. The linear photoelectric focal plane detector according to claim 6, wherein the metal pad transmits the photoelectric conversion signal processed by the readout circuit to the external interface by means of wire bonding.

8. The linear photoelectric focal plane detector according to claim 1, wherein the photosensitive pixels are in a plurality of rows, with each row of the photosensitive pixels having the same size of photosensitive surface.

9. A manufacturing method for a linear photoelectric focal plane detector, comprising:
providing a plurality of rows of first metal electrodes on an upper surface of a readout circuit; the first metal electrodes in each row being arranged in parallel at equal intervals in a row direction, and the first metal electrodes in adjacent rows being arranged in a staggered manner in the row direction;
obtaining a plurality of photosensitive chips of different types; each photosensitive chip comprising at least one row of photosensitive pixels arranged in parallel;
providing second metal electrodes arranged in parallel at equal intervals in the row direction on a lower surface of each photosensitive chip; at least one row of the second metal electrodes being correspondingly connected to the first metal electrodes.

10. The manufacturing method for the linear photoelectric focal plane detector according to claim 9, further comprising:
providing a first metal interconnection bump protruding from the first metal electrode and a second metal interconnection bump protruding from the second metal electrode;
forming an interconnection layer based on the first metal interconnection bump and the second metal interconnection bump;
and/or,
electrically connecting the photosensitive pixel to the second metal electrode using a signal electrode.
